Europäisches Patentamt

**European Patent Office**

**Office européen des brevets**

(11) Publication number:

# 0 072 154
A2

## (12) EUROPEAN PATENT APPLICATION

(21) Application number: 82304010.0

(51) Int. Cl.³: **H 03 K 5/04, G 01 S 7/28**

(22) Date of filing: 29.07.82

(30) Priority: 08.08.81 GB 8124321

(43) Date of publication of application: 16.02.83 Bulletin 83/7

(84) Designated Contracting States: AT BE CH DE FR IT LI LU NL SE

(71) Applicant: THE MARCONI COMPANY LIMITED, The Grove Warren Lane, Stanmore Middlesex HA7 4LY (GB)

(72) Inventor: Richardson, Robert, 42, King Edwards Road, South Woodham Ferrers Chelmsford Essex (GB)

(74) Representative: Hoste, Colin Francis et al, Marconi House New Street, Chelmsford Essex CM1 1PL (GB)

(54) **Pulse circuits for generating very high voltage pulses.**

(57) A pulse circuit uses a transformer to convert a high current pulse at relatively low voltage into a very high voltage pulse which is able to directly drive a magnetron oscillator. The circuit forms part of a radar transmitter in which the transmitted pulse lengths are to be varied. It is not satisfactory to alter the structure of the transformer or that of a pulse forming network which is used to feed the transformer when variation in the pulse length is required. The invention provides a bias circuit which magnetically biasses the core material of the transformer, so that when a pulse is subsequently applied to the transformer the flux of the core material saturates after a predetermined interval of time which is dependent on the bias level. In this way accurate control of pulse length can be achieved and the characteristics of the pulse forming network and the transformer are used to determine the rising and falling edges of microwave pulses generated by the magnetron.

Pulse Circuits

This invention relates to pulse circuits in which a transformer is used to convert a high current pulse at relatively low voltage into a very high voltage pulse. A circuit of this kind can be used to provide the operating power for a high power oscillator, such as a magnetron, which forms part of a radar transmitter. Such a pulse circuit is sometimes termed a radar pulse modulator. A radar transmitter transmits pulses having a very low mark-to-space ratio, that is to say, transmitted short pulses are spaced apart in time by relatively long intervals during which radar echoes of the pulses are returned by intercepted radar targets to a radar receiver. The useful range of a radar is related to the power transmitted during the short pulse periods and it is therefore very important to maximise the power of these pulses, whilst ensuring that the pulses turn on and turn off cleanly, i.e. without the generation of excessive noise or the wasteful dissipation of power. Following the turn off, or decay, of a transmitted short pulse, the receiver of the radar is enabled so that it can detect weak radar echoes and it is clearly important to ensure that the trailing edges of the transmitted short pulses decay very rapidly and cleanly so that they do not mask echoes received after only a very short delay from targets at very close range.

Whilst it is possible to produce a short pulse of fixed length using a carefully designed pulse transformer to transform a low voltage pulse up to a voltage level at which it will drive a magnetron oscillator, it is very difficult to accurately vary the pulse length without degrading the shape of the transmitted pulses or impairing the efficiency of the radar system. The present invention seeks to provide an improved pulse circuit in which this disadvantage is reduced.

According to this invention, a pulse circuit includes a pulse transformer arranged to receive a low voltage high current pulse from a pulse generator and to transform it into a high voltage pulse for utilisation by a load, the duration of the high voltage pulse being determined by the time taken for the reactor of the pulse transformer to saturate; and means for biassing the magnetic flux state of the pulse transformer to a selectable level prior to the reception of the low voltage pulses whereby the duration of the high voltage pulses produced by the transformer is reduced from a predetermined maximum value by an amount related to the selectable bias level.

The characteristics of the low voltage high current pulse and the pulse transformer are preferably chosen so that the longest required output pulse is obtained without the need to bias the magnetic flux of the pulse transformer. When shorter pulses than this are required an appropriate level of magnetic flux bias is applied to ensure that the magnetic material of the pulse transformer saturates at the end of the pulses, as this causes the voltage on the output of the pulse transformer to decay rapidly. When the pulse transformer is used to drive a magnetron, this characteristic enables the microwave output signal from the magnetron to decay rapidly and cleanly without the generation of excessive noise signals.

The invention is further described by way of example with reference to the accompanying drawings, in which

Figure 1 shows a pulse circuit forming part of a radar transmitter,

Figure 2 is an explanatory diagram relating to the magnetic characteristics of a pulse transformer,

Figure 3 shows part of the pulse circuit in greater detail, and Figures 4 and 5 are further explanatory diagrams.

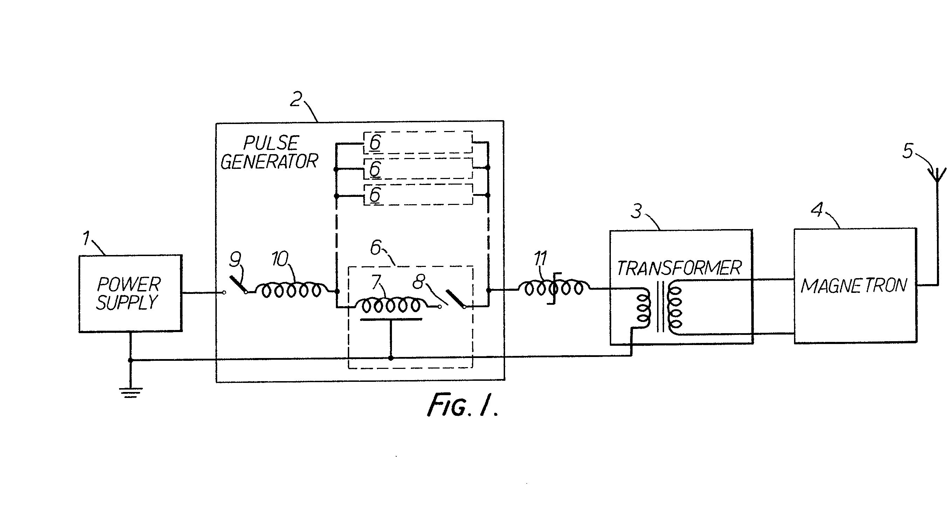

Figure 1 shows those parts of a radar transmitter which are relevant to an understanding of the present invention. The radar transmitter transmits very short pulses having a very high carrier frequency (usually in the microwave band), and during the interval (usually termed the inter-pulse period) following the cessation of each pulse, a radar receiver (not shown) receives relatively weak echoes of the transmitted pulse which is reflected by targets. The echoes may be very weak indeed and they are often difficult to detect from the background noise. Consequently, it is important that the radar transmitter itself does not generate electrical noise during the intervals between transmitted pulses. In order to maximise the level of the echo signals, the power of the transmitted pulses is made as large as possible, and the radar system must be designed with care to ensure that these pulses which have a very high power level decay very rapidly, so that weak echo signals which occur immediately afterwards can be detected. Thus Figure 1 shows just those parts of a radar transmitter which are concerned with the generation of very short but high power pulses.

A d.c. power supply 1 generates an output voltage of about 600 volts and applies it to a pulse generator 2 which is operative to utilise the d.c. voltage to produce a sequence of pulses having a low mark-to-space ratio corresponding to the pulses which are to be transmitted by the radar, but having a relatively low voltage, but very high current. These pulses are transformed by a pulse transformer 3 from the 600 volt level up to about 30 kV so that they can be used to drive a magnetron 4 directly. A magnetron is a relatively efficient and satisfactory generator of microwave power, but it requires the provision of very high operating voltages. The output of the magnetron 4 is transmitted via a radar antenna 5. The magnetron 4 is such as to oscillate at microwave frequencies whenever a sufficiently high voltage is applied to it, and the shape of the transmitted pulses and the efficiency with which they are transmitted is primarily dependent on the nature of the pulses generated at the pulse generator 2 and the way in which they are transformed from a low voltage to a high voltage by the transformer 3.

The pulse generator 2 utilises a number of pulse forming networks to generate an output pulse having the required characteristic. A pulse forming network consists of a distributed network of inductance and capacitance, and during the inter-pulse periods the network is charged from the power supply 1 at a relatively low current level. As the inter-pulse periods are long compared to the pulse periods themselves, the pulse forming networks are able to accumulate a great deal of energy. A mark-to-space ratio of the order of 1 to 1000 is typically of many radars. When an output pulse is required the pulse forming networks are discharged rapidly, but the characteristics of the pulse forming networks enable relatively square pulses to be produced - that is to say, a flat-topped pulse having very steep rising and falling edges.

It is these pulses which are transformed by the transformer 3 to the high voltage of about 30 kV which is necessary to drive the magnetron 4. It will be appreciated that the switches which are used to discharge the pulse forming networks must conduct a great deal of current and must be relatively robust and reliable. In Figure 1, these switches are constituted by thyristors, which are solid state devices and which at the present time cannot reliably withstand voltages much greater than 1000 volts. Therefore in order to achieve the necessary power levels a number of pulse forming networks together with their respective switches are connected in parallel. Typically at least eight such pulse forming networks are connected in parallel.

Only one of the pulse modules 6 is shown in detail, but all are identical to each other. Each module 6 consists of a pulse forming network 7 comprising a network of distributed inductance and capacitance, connected in series with a thyristor 8. The modules 6 are connected in parallel with each other, and to the power supply 1 via a common switch 9 and a choke 10. The modules 6 are coupled to the primary winding of the transformer 3 via a saturable reactor 11.

Briefly, the operation of the radar system shown in Figure 1 is as follows. Initially, the switches 8 and 9 are non-conductive and the pulse forming networks 7 are assumed to be fully discharged. Switch 9 is then closed so that all of the pulse forming networks 7 are charged from the 600 volt d.c. power supply 1 via the choke 10 - the choke 10 is present to moderate the magnitude of the initial charging current when the switch 9 is first closed. The pulse forming networks 7 charge during the inter-pulse period, which can be relatively long, so that they become fully charged. When an output pulse is required, the switches 8 are rendered conductive. As the switches 8 are solid state thyristors they take a finite time to change from a fully non-conductive state to a fully conductive state, and if appreciable current were allowed to flow through them during the transition phase a great deal of power would be dissipated within them. To prevent this happening the saturable reactor 11 is provided - it initially behaves as an inductor and therefore controls the rate at which the build up of current can occur, but it rapidly saturates and then behaves as a very low inductance. The time taken to saturate is tailored to the switching time of the switches 8 so that once the switches 8 are fully conductive, the saturable reactor 11 appears in effect as a short circuit allowing the pulse forming networks 7 to very rapidly discharge. This rapid discharge is a high current pulse which is transformed by the transformer 3 up to the required operating voltage of the magnetron - typically about 30 kV.

The magnetron has significant capacitance associated with it and when the current pulse ceases it may remain charged. Since a magnetron is operative to generate microwave energy whilst a voltage above a threshold is applied to it, it is liable to generate noise which tapers off relatively slowly so long as its capacitance remainds charged. Therefore the pulse forming networks 7 are chosen in relation to the operating characteristics of the transformer 3 so that the magnetic material of the tranformer saturates at the same time as, or shortly before, the pulse forming networks 7 become fully discharged. Under these circumstances the output voltage of the transformer 3 (which constitutes the voltage applied to the magnetron 4) collapses very rapidly thereby preventing the magnetron emitting spurious or unwanted noise.

The above arrangement works very well when the radar system is to transmit pulses having only one duration determined primarily by the characteristics of the pulse forming network and the pulse transformer, but often it is desired to transmit pulses of various different lengths. For example, for long range work it is desired to maximise the transmitted power, and under such circumstances relatively long radar pulses are transmitted. However, the detection of targets at very close range requires the transmission of very short pulses so that the pulse terminates by the time that echoes of it begin to be received. It is extremely difficult and unsatisfactory to switchably select different transformers in dependence on the required pulse length, but switchably, or electrically, programmable pulse forming networks are relatively straight forward.

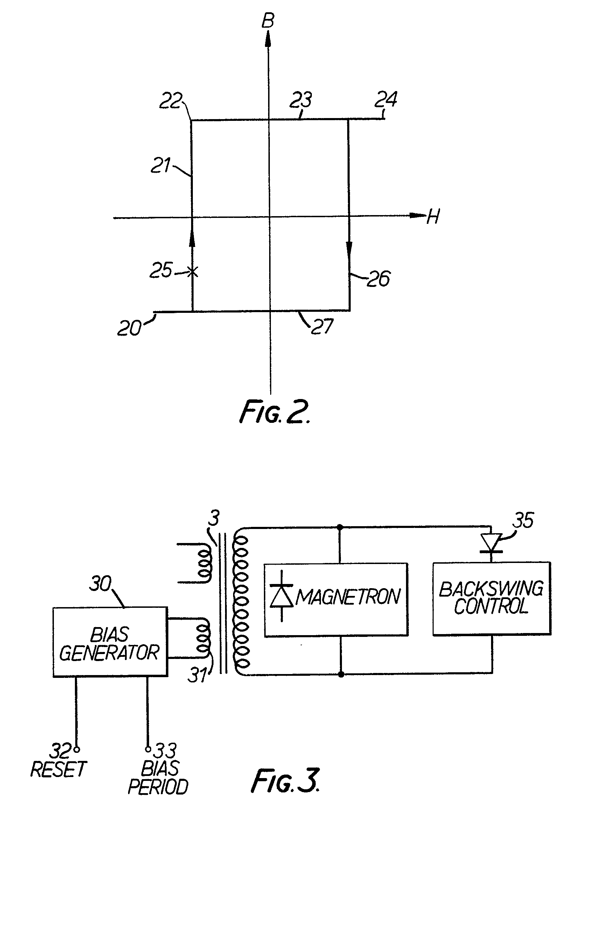

The required variation in output pulse length is achieved by modifying the magnetic properties of a single transformer 3 in conjunction with the selection of the appropriate pulse forming network. Figure 2 shows the magnetic characteristics of the pulse transformer 3. It has a very square B-H hysteresis loop (the value of remanent to maximum flux density is preferably between 0.9 and 1). Prior to the application of a pulse from the pulse generator 2, the magnetic flux state of the transformer is re-set to point 20. Then when the pulse is applied to the primary winding of the transformer 3, the magneting force associated with the pulse causes the flux state to shift along curve 21 and it is arranged that the longest required pulse terminates at the time that point 22 is reached. Since the portion 23 of the B-H curve is almost flat, the flux state switches almost instantaneously to point 24 when the point 22 is reached. Thus, in practice, the output pulse of the transformer is obtained whilst the magnetic flux of the core material of the transformer switches between points 20 and 24.

In order to accommodate pulse lengths which are shorter than the maximum, the magnetic core material is initially biassed from the re-set point 20 to an intermediate point, such as point 25, so that when the pulse from the pulse generator is applied to the transformer the point 22 at which the output pulse collapses is reached more quickly - therefore the output pulse is shorter. Since the transformer saturates at this point, the voltage on the magnetron 4 also collapses rapidly and thus the magnetron transmits a shorter pulse without the generation of subsequent spurious noise during its turn-off period.

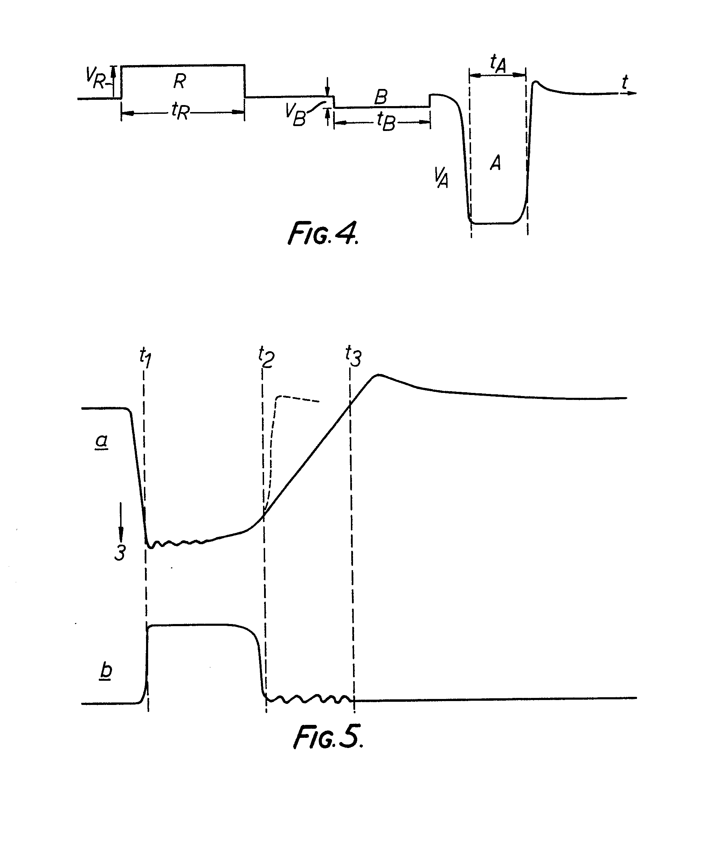

Figure 3 illustrates the way in which a bias level is applied to the pulse transformer 3, and the mode of operation is explained with reference to Figure 4. Assuming that initially an output pulse has just been transmitted and that the magnetic flux of the transformer is at point 24, a re-set pulse R is generated when a re-set signal is applied via terminal 32 to a bias generator 30. This generates a pulse which is fed by means of an auxiliary winding 31 to the transformer 3. The magnitude and duration of this re-set pulse R is shown in Figure 4 and it has an amplitude $V_R$ and duration $t_R$. The product $V_R t_R$ is chosen to be sufficiently large as to re-set the magnetic material from point 24 of the Figure 2 to point 20 (via paths 26 and 27). Since the period $t_R$ can correspond to the relatively long inter-pulse period, the voltage $V_R$ can be relatively modest. Subsequently, and preferably immediately prior to the generation of an output pulse, a bias pulse B is generated by the bias generator 30 and applied to the transformer 3 via the auxiliary winding 31. The bias pulse B is generated so long as a bias signal is present at terminal 33 of the bias generator 30. The bias pulse B has an amplitude $V_B$ and period $t_B$ and the product $V_B t_B$ is chosen so as to shift the magnetic flux of the core material from point 20 to 25. Although it is preferred to vary the product $V_B t_B$ by adjusting $t_B$ whilst holding $V_B$ constant, this is not necessary as in principle $V_B$ could also be very varied within certain limits, providing care is taken not to inadvertently operate the magnetron at a voltage where it may emit spurious noise.

Subsequently, when the pulse forming networks 7 are discharged by the action of switches 8, a pulse A having an amplitude $V_A$ is generated by the transformer and applied to the magnetron 4. The amplitude $V_A$ is, of course, determined by the windings ratio of the transformer 3 and in this example the windings ratio is such as to transform an input pulse of about 600 volts up to an output pulse of about 30 kV. The duration of this pulse A is $t_A$ and is determined by the time taken for the magnetic flux to reach point 22 at which it saturates. The magnetic properties of the core are stable and predictable, so that by choosing the shape of the pulse B, the duration of the subsequent pulse A can be accurately controlled. It is, of course, necessary to ensure that the magnitude $V_B$ of the bias pulse B is relatively small so that it does not approach the operating threshold voltage value of the magnetron 4.

Figure 5 is used to further explain the operation of the circuit shown in Figure 3 and to explain the problem which the present invention overcomes. Line $\underline{a}$ shows the magnitude of the voltage which would be present on a magnetron if a relatively short pulse were applied to the pulse transformer 3 so that the pulse terminated before the magnetic material of the transformer had saturated. The current pulse generated by the pulse generator 2 commences at time $t_1$ and ceases at time $t_2$, but at time $t_2$ the capacitance of the magnetron 4 remains charged and decays only slowly to reach zero at time $t_3$. During the time $t_2$ to $t_3$ the magnetron is liable to emit random oscillations and unwanted noise which could seriously interfere with the reception of a weak echo from a radar target. At time $t_3$, the polarity of the voltage applied to the magnetron reverses and is clipped by means of a diode 35, so that it is of no effect. Once the voltage has passed through zero at time $t_3$, any voltage oscillations which occur can be clamped by means of a back swing control circuit, which could be conventional in nature. Line $\underline{b}$ of Figure 5 shows the output pulse of the magnetron occurring between times $t_1$ and $t_2$, and this is followed by spurious noise until time $t_3$. However, as previously described the present invention eliminates the relatively slow decay of the voltage on the magnetron which occurs between times $t_2$ and $t_3$ thereby avoiding the generation of unwanted noise. The voltage on the magnetron decays rapidly at time $t_2$, as is shown in broken line at $\underline{a}$, and the noise shown at $\underline{b}$ is eliminated.

Claims

1. A pulse circuit including a pulse transformer arranged to receive a low voltage high current pulse from a pulse generator and to transform it into a high voltage pulse for utilisation by a load, the duration of the high voltage pulse being determined by the time taken for the reactor of the pulse transformer to saturate; and means for biassing the magnetic flux state of the pulse transformer to a selectable level prior to the reception of the low voltage pulses whereby the duration of the high voltage pulses produced by the transformer is reduced from a predetermined maximum value by an amount related to the selectable bias level.

2. A pulse circuit including a pulse transformer arranged to receive a low voltage high current pulse from a pulse generator and to transform it into a high voltage pulse for utilisation by a load, the duration of the high voltage pulse being determined by the time taken for the reactor of the pulse transformer to saturate; and means for biassing the magnetic flux state of the pulse transformer to a selectable level prior to the reception of the low voltage pulses whereby the duration of the high voltage pulses produced by the transformer is reduced from a predetermined maximum value by an amount related to the selectable bias level, wherein said selectable level is obtained by applying a bias pulse of controllable voltage level and duration to a winding of the pulse transformer.

3. A circuit as claimed in claim 2 and wherein the magnetic flux state is biassed by means of a bias winding which is provided in the transformer in addition to the primary and secondary windings which generate the pulse.

4. A circuit as claimed in claim 3 and wherein the bias winding is a primary winding.

5. A circuit as claimed in claim 2, 3 or 4 and wherein the means for biassing the magnetic flux state includes a bias pulse generator arranged to provide an output pulse of predetermined constant voltage, but of variable duration which is chosen in relation to required length of the high voltage pulse.

6.   A circuit as claimed in claim 3 and wherein the bias winding is utilised to re-set the magnetic flux state of the pulse transformer to an initial reference value prior to the bias pulse.

7.   A circuit as claimed in any of the preceding claims and wherein the load is a magnetron oscillator.

8.   A radar transmitter including a pulse circuit as claimed in any of the preceding claims.

0072154

Fig. I.

**FIG. 2.**

**FIG. 3.**

FIG. 4.

FIG. 5.